## Europäisches Patentamt

(19) **European Patent Office**

**Office européen des brevets**

(11) Veröffentlichungsnummer: **0 164 620**
**B1**

(12) # EUROPÄISCHE PATENTSCHRIFT

(45) Veröffentlichungstag der Patentschrift:
25.10.89

(51) Int. Cl.⁴: **G 03 F 7/08,** G 03 F 7/16

(21) Anmeldenummer: **85106264.6**

(22) Anmeldetag: **22.05.85**

(54) Positiv-arbeitende strahlungsempfindliche Beschichtungslösung.

(30) Priorität: **11.06.84 US 619468**

(43) Veröffentlichungstag der Anmeldung:
**18.12.85 Patentblatt 85/51**

(45) Bekanntmachung des Hinweises auf die Patenterteilung:
**25.10.89 Patentblatt 89/43**

(84) Benannte Vertragsstaaten:
**BE CH DE FR GB IT LI NL SE**

(56) Entgegenhaltungen:
**EP-A-0 042 104**
**EP-A-0 164 083**
**EP-A-0 164 248**

**CHEMICAL ABSTRACTS, Band 48, Nr. 22, 25.
November 1954, Zusammenfassung Nr. 13951f,
Columbus, Ohio, US; V.K. ROWE et al.:
"Toxicology of mono-, di-, and tri-propylene glycol
methyl ethers", & ARCH. IND: HYG.
OCCUPATIONAL MED. 9, 509-25
Paint + Resin, Bd. 53 (1983), Nr. 5, Seiten 42-47**

(73) Patentinhaber: **HOECHST CELANESE
CORPORATION, Route 202- 206 North, Somerville,
N.J. 08876 (US)**

(72) Erfinder: **Pampalone, Thomas R., 42 Essex Drive,
Mendham New Jersey 07945 (US)**

(74) Vertreter: **Euler, Kurt Emil, Dr., KALLE
Niederlassung der Hoechst AG Rheingaustrasse
190 Postfach 3540, D-6200 Wiesbaden 1 (DE)**

**Beschreibung**

Die vorliegende Erfindung betrifft eine positiv-arbeitende strahlungsempfindliche Beschichtungslösung, die als wesentliche Bestandteile mindestens ein wasserunlösliches, in wäßrig-alkalischen Lösungen lösliches Bindemittel, wie ein Novolakharz, mindestens eine strahlungsempfindliche Verbindung, wie ein o-Chinondiazid, und ein organisches Lösungsmittel bzw. Lösemittelgemisch aus oder mit einem Glykoletherester enthält.

Die Herstellung von positiv-arbeitenden Photoresists ist bekannt (US-A-3 666 473, US-A-4 115 128 und US-A-4 173 470). Dabei handelt es sich um alkalilösliche Phenolformaldehyd-Novolakharze in Verbindung mit lichtempfindlichen Stoffen, gewöhnlich einer substituierten Naphthochinondiazidverbindung. Die Harze und Sensibilisatoren werden in einem organischen Lösemittel oder Lösemittelgemisch gelöst und können vom Hersteller der Schichten oder vom Verbraucher als dünne Schicht bzw. Beschichtung auf einen für den vorgesehenen Verwendungszweck geeigneten Träger aufgebracht werden.

Die Novolakharzkomponente ist in wäßrig-alkalischen Lösungen löslich, wobei aber der Naphthochinonsensibilisator als Auflösungsverzögerer auf das Harz wirkt. Wenn jedoch bestimmte Bereiche des beschichteten Trägers mit aktinischer Strahlung belichtet werden, durchläuft der Sensibilisator eine durch die Bestrahlung induzierte strukturelle Umwandlung, und die belichteten Bereiche der Beschichtung werden löslicher als die unbelichteten. Durch diesen Löslichkeitsunterschied lösen sich die belichteten Bereiche der Photoresistschicht beim Eintauchen in eine alkalische Entwicklerlösung, während die unbelichteten Bereiche weitgehend unbeeinträchtigt bleiben, so daß auf dem Träger ein positives Reliefbild entsteht.

In den meisten Fällen wird der entwickelte Träger mit einer Ätzlösung behandelt. Dabei schützt die Photoresistschicht die beschichteten Bereiche des Trägers vor dem Ätzmittel, so daß dieses nur die unbeschichteten Bereiche ätzen kann. Das sind bei einem positiv arbeitenden Resist die mit aktinischer Strahlung belichteten Bereiche. Es kann also auf dem Träger ein Ätzmuster entsprechend dem Bild der Maske, Schablone usw. erzeugt werden.

Das nach dem oben beschriebenen Verfahren hergestellte Reliefbild aus Photoresist auf dem Träger eignet sich für verschiedene Anwendungszwecke, zum Beispiel als Maske oder Bild, etwa zur Herstellung von miniaturisierten integrierten elektronischen Komponenten.

Für die produktionstechnische Nutzung eines Photoresists wichtige Eigenschaften sind die folgenden: Lichtempfindlichkeit, Entwicklungskontrast, Auflösung und seine Haftung auf dem Träger.

Eine erhöhte Lichtempfindlichkeit ist wichtig für einen Photoresist, insbesondere wenn er für Anwendungen eingesetzt wird, bei denen mehrere Belichtungen erforderlich sind, z. B. bei der Erzeugung von Mehrfachbildern durch ein Wiederholungsverfahren oder in Fällen, in denen Licht mit abgeschwächter Intensität verwendet wird, z. B. in der Projektionsbelichtungstechnik, bei der das Licht eine Reihe von Objektiven und monochromatischen Filtern durchläuft. Eine erhöhte Lichtempfindlichkeit ist also ganz besonders wichtig für ein Resistgemisch, das in Verfahren eingesetzt wird, bei denen Mehrfachbelichtungen (Stepper) durchgeführt werden müssen, um eine Maske oder eine Serie von Schaltbildern auf einem Träger zu erzeugen. Optimale Bedingungen ergeben sich durch eine gleichbleibende Entwicklungstemperatur und -zeit bei einer bestimmten Entwicklungsart sowie durch ein Entwicklersystem, das so ausgewählt ist, daß ein vollständiges Ausentwickeln der belichteten Resistbereiche erreicht und gleichzeitig der Dickenverlust der unbelichteten Resistbereiche bei höchstens etwa 10 % der anfänglichen Dicke gehalten wird.

Unter Entwicklungskontrast ist der Unterschied zwischen dem Prozentanteil des Schichtverlusts im belichteten Bereich nach dem Entwickeln und dem Prozentanteil des Schichtverlusts im unbelichteten Bereich zu verstehen. Normalerweise wird ein mit einem belichteten Resist beschichteter Träger so lange entwickelt, bis die Schicht im belichteten Bereich sich im wesentlichen vollständig abgelöst hat. Der Entwicklungskontrast kann daher dadurch bestimmt werden, daß nach dem vollständigen Ablösen der belichteten Schichtbereiche einfach der Prozentanteil des Schichtverlusts in den unbelichteten Bereichen gemessen wird.

Unter Auflösung des Resists versteht man die Fähigkeit eines Resistsystems zur Wiedergabe der feinsten, im gleichen Abstand voneinander angeordneten Linienpaare und der kleinsten zugehörigen Zwischenräume einer für die Belichtung verwendeten Maske, mit einem hohen Grad an Kantenschärfe des Bildes in den ausentwickelten belichteten Zwischenräumen.

Für viele technische Anwendungen, insbesondere für die Herstellung von miniaturisierten elektronischen Komponenten muß ein Photoresist einen hohen Auflösungsgrad aufweisen, wenn er sehr kleine Linien- und Zwischenraumbreiten (in der Größenordnung von 1 μm) wiedergeben soll.

Die Fähigkeit eines Resists zur Wiedergabe sehr kleiner Abmessungen in der Größenordnung von 1 μm und darunter ist bei der Herstellung von LSI-Schaltungen auf Siliziumchips und ähnlichen Komponenten von größter Bedeutung. Die Schaltungsdichte auf einem solchen Chip kann nur durch eine Steigerung des Auflösungsvermögens des Resists - vorausgesetzt, es wird mit photolithographischen Verfahren gearbeitet - erhöht werden. Obwohl negativ arbeitende Photoresists, bei denen die belichteten Bereiche der Resistschicht im Entwickler unlöslich und die unbelichteten Bereiche vom Entwickler abgelöst werden, von der Halbleiterindustrie in großem Umfang für diesen Zweck verwendet werden, haben doch die positiv-arbeitenden Photoresists von ihrer Natur her eine höhere Auflösung und werden als Ersatz für die negativ-arbeitenden Resists eingesetzt.

Beim Einsatz von herkömmlichen positiv-arbeitenden Photoresists für die Herstellung von miniaturisierten Komponenten für integrierte Schaltungen besteht die Schwierigkeit, daß die positiv-arbeitenden Resists im allgemeinen eine geringere Lichtempfindlichkeit haben als die negativ-arbeitenden Resists.

Es sind verschiedene Versuche unternommen worden, die Lichtempfindlichkeit positiv-arbeitender Photoresistgemische zu verbessern. In US-A-3 666 473 wird zum Beispiel ein Gemisch aus zwei Phenolformaldehyd-Novolaken zusammen mit einem üblichen Sensibilisator verwendet, wobei diese Novolakharze durch ihre Lösungsgeschwindigkeit in alkalischen Lösungen eines bestimmten pH-Werts und durch ihren Trübungspunkt definiert sind.

In US-A-4 115 128 wird zur Steigerung der Lichtempfindlichkeit dem Phenolharz und dem als Sensibilisator verwendeten Naphthochinondiazid eine aus einem zyklischen Anhydrid einer organischen Säure bestehende dritte Komponente hinzugefügt.

Als Lösungsmittel oder Lösemittelgemische werden in US-A-3 666 473 die verschiedensten Stoffe genannt, wie Ether, Ester und Ketone, etwa Methyl- oder Ethyl-Cellosolveacetat mit oder ohne Anteilen an Butylacetat und Xylol, Glykolmonomethyl- bzw. -monoethylether und Methylisobutylketon oder Aceton. Weiterhin gehen aus Photoresistrezepturen gemäß US-A-4 439 516, die höheren Temperaturen standhalten sollen, als Lösungsmittel Alkohole, Ether und Amide, wie Dimethylformamid, Cellosolveester und Glykolester oder Glykolether, hervor. Entsprechende Lösungsmittel sind auch aus US-A-4 397 973 und US-A-4 308 368 zu entnehmen.

Bei der Auswahl der Lösungsmittel wird in diesen Schriften jedoch keine Rücksicht auf eventuell erfolgende Umweltbelastungen durch das Lösungsmittel genommen, sei es bei den Herstellern der Lösungen, sei es bei den Herstellern des Photoresists. Zum Beispiel besitzen viele Verbraucher, die nur in kleinem Umfang beschichten, keine Einrichtungen zur Rückgewinnung oder umweltfreundlichen Beseitigung der Lösungsmitteldämpfe. Da jedoch die Normen für die Zulassung organischer Lösemittel strenger geworden sind, ist auch die Auswahl der Lösemittel stark eingeschränkt worden.

Außerdem beeinflussen die bekannten Lösemittel oder Lösemittelgemische die Lichtempfindlichkeit nicht in positivem Sinne.

In J. E. Hamlin, New Propylene Glycol Ethers and Acetates, Paint & Resin 53 (5), Oktober 1983, Seiten 42 - 47, wird die Verwendung von Glykolethern und -estern, wozu auch Propylenglykolderivate zählen, als Lösemittel in Druckfarben und Beschichtungslösungen genannt. Von den genannten Lösemitteln werden verschiedene physikalische Eigenschaften beschrieben, aus denen aber nicht hervorgeht, daß bestimmte Lösemittel, eingesetzt in lichtempfindlichen Gemischen, einen Einfluß auf Lichtempfindlichkeit und Entwicklungskontrast ausüben.

Es war Aufgabe der vorliegenden Erfindung, eine Photoresistlösung vorzuschlagen, deren Lösemittel in bezug auf Siedepunkt, Dampfdruck, Lösevermögen, den bisher verwendeten Lösemitteln entspricht, die jedoch eine günstigere Lichtempfindlichkeit bei gleichbleibend guten weiteren Erfordernissen besitzt und weniger gesundheitsgefährdend ist.

Diese Aufgabe wird durch eine Beschichtungslösung der eingangs genannten Art dadurch gelöst, daß sie als Glykoletherester ein Propylenglykol-$C_1$-$C_2$-alkyletheracetat, enthält.

Hierdurch wird erreicht, daß ein Photoresistgemisch zur Verfügung gestellt werden kann, das eine wesentlich größere Lichtempfindlichkeit aufweist und dabei in bezug auf den Schichtabtrag des Photoresists, die Plasmaätzrate und den Kontrast unverändert oder sogar verbessert ist. Überraschenderweise wurde gefunden, daß ein verbesserter Photoresist hergestellt werden kann, wenn man das Novolakharz und den Chinondiazid-Photosensibilisator mit einer Propylenglykol-$C_1$-$C_2$-alkyletheracetat-Komponente mischt.

Diese Komponente wirkt auch als Lösemittel für das Harz und den Photosensibilisator und erleichtert so das Aufbringen des Photoresists auf einen Träger. Die Komponente hat dabei gegenüber anderen bekannten geeigneten Lösemitteln eine geringere Toxizität.

Die Verwendung von Propylenglykolalkylethern ist aus anderen Anwendungsbereichen, zum Beispiel zur Behandlung von lichtempfindlichen Schichten nach der bildmäßigen Belichtung und Entwicklung im Gemisch mit anderen organischen Lösungsmitteln und Wasser bekannt (US-A-4 411 983, entsprechend DE-OS-2 916 384) oder als Bestandteil einer Entwicklerlösung (US-A-4 416 976, entsprechend DE-OS-3 012 522). Hieraus war aber nicht erkennbar, daß sich die Propylenglykol-$C_1$-$C_2$-alkyletheracetate ganz besonders gut erfindungsgemäß in Beschichtungslösungen einsetzen lassen.

Ganz besonders bevorzugt enthält die erfindungsgemäße Beschichtungslösung Propylenglykolmethyletheracetat.

Die erfindungsgemäßen Photoresistgemische weisen nicht nur eine erhöhte Lichtempfindlichkeit gegenüber bekannten positiv-arbeitenden Photoresists auf, sondern besitzen auch einen hohen Auflösungsgrad, einen guten Entwicklungskontrast und gute Haftungseigenschaften. Mit diesen Eigenschaften unterscheiden sie sich deutlich von bekannten Photoresists, die zwar eine mäßig gesteigerte Lichtempfindlichkeit besitzen, allerdings auf Kosten von Auflösungsvermögen und Kontrast.

Die erfindungsgemäße Beschichtungslösung enthält das Propylenglykol-$C_1$-$C_2$-alkyletheracetat in einer Menge von 5 bis 100 Gewichtsprozent, bezogen auf das Lösemittel. In besonderer Ausführungsform enthält die Beschichtungslösung das Propylenglykol-$C_1$-$C_2$-alkyletheracetat allein.

Die Produktion von Novolakharzen, die für die Herstellung von lichtempfindlichen Gemischen verwendet werden können, ist bekannt. Ein Verfahren zu ihrer Herstellung ist in "Chemistry and Application of Phenolic Resins", von A. Knop und W. Scheib, New York, Springer Verlag, 1979, Kapitel 4, beschrieben. Es ist auch die Verwendung von strahlungsempfindlichen o-Chinondiaziden bekannt, wie sie in "Light Sensitve Systems" von J. Kosar, New York, John Wiley & Sons, 1965, Kapitel 7.4, beschrieben wird. Diese Sensibilisatoren, die eine Komponente der erfindungsgemäßen Beschichtungslösungen bilden, gehören zur Gruppe der substituierten Naphthochinondiazid-Sensibilisatoren, wie sie üblicherweise in positiv-arbeitenden Photoresistansätzen verwendet werden. Solche sensibilisierenden Verbindungen sind zum Beispiel aus US-A-2 797 213, US-A-3 106 465, US-A-3 148 983, US-A-3 130 047, US-A-3 201 329, US-A-3 785 825 und US-A-3 802 885 bekannt. Geeignete Photosensibilisatoren sind zum Beispiel mit phenolischen Verbindungen, wie Hydroxy-benzophenonen, kondensiertes 1,2-Naphthochinondiazid-5-sulfonylchlorid und 1,2-Naphthochinondiazid-4-sulfonylchlorid.

Das Novolakharz ist in einem Anteil von etwa 50 bis 90 Gewichtsprozent, insbesondere von etwa 65 bis 85 Gewichtsprozent, bezogen auf das Gewicht der festen Bestandteile des Photoresists, in der Beschichtungslösung enthalten. Der Anteil an Diazid liegt vorteilhaft bei etwa 10 bis 50, insbesondere bei etwa 15 bis 35 Gewichtsprozent, bezogen auf das Gewicht der festen Bestandteile des Photoresists. Zur Herstellung der Beschichtungslösung werden Novolak und Diazid so mit dem Propylenglykolalkyletheracetat gemischt, daß das Acetat in einem Anteil von etwa 40 bis 90 Gewichtsprozent, bezogen auf die Beschichtungslösung, anwesend ist. Vorzugsweise liegt der Anteil an Acetat bei etwa 60 bis 83, insbesondere bei etwa 65 bis 70 Gewichtsprozent, bezogen auf die Beschichtungslösung.

Der Lösung aus Novolakharz, Sensibilisator und Propylenglykolalkyletheracetat können vor dem Aufbringen auf einen Träger noch Zusätze, wie zum Beispiel Farbstoffe, Verlaufmittel. Weichmacher, Haftvermittler, Entwicklungsbeschleuniger, Lösemittel und Tenside, zum Beispiel nicht-ionische Tenside, zugegeben werden.

Farbstoffe, die verwendet werden können, sind zum Beispiel Methylviolett 2B (C.I. 42 535), Kristallviolett (C.I. 42 555), Malachitgrün (C.I. 42 000), Victoriablau B (C.I. 44 045) und Neutralrot (C.I. 50 040). Diese Farbstoffe werden in einer Menge von 1 bis 10 Gewichtsprozent, bezogen auf das gemeinsame Gewicht von Novolakharz und strahlungsempfindlicher Verbindung, zugesetzt. Die Farbstoffzusätze verringern die Lichtreflexion vom Träger und tragen so zu einer verbesserten Auflösung bei.

Verlaufmittel können in einer Menge bis zu 5 Gewichtsprozent, bezogen auf das gemeinsame Gewicht von Novolak und strahlungsempfindlicher Verbindung, eingesetzt werden.

Geeignete Weichmacher sind zum Beispiel Phosphorsäuretri-($\beta$-chlorethyl)-ester, Stearinsäure, Kampfer, Polypropylen, Acetalharze, Phenoxyharze und Alkydharze, die in Anteilen von 1 bis 10 Gewichtsprozent, bezogen auf das gemeinsame Gewicht von Novolak und strahlungsempfindlicher Verbindung, zugesetzt werden können. Die Weichmacherzusätze verbessern die Beschichtungseigenschaften des Materials und ermöglichen das Auftragen einer glatten und gleichmäßig dicken Schicht auf den Träger.

Geeignete Haftvermittler sind zum Beispiel Hexamethyldisilazan, $\beta$-(3,4-Epoxycyclohexyl)-ethyltrimethoxysilan, p-Methyldisilan-methylmethacrylat, Vinyltrichlorsilan und $\gamma$-Aminopropyltriethoxysilan in einem Anteil bis zu 4 Gewichtsprozent, bezogen auf das gemeinsame Gewicht von Novolak und strahlungsempfindlicher Verbindung.

Als Entwicklungsbeschleuniger können beispielsweise Pikrinsäure, Nikotinsäure oder Nitrozimtsäure in einem Anteil bis zu 20 Gewichtsprozent, bezogen auf das gemeinsame Gewicht von Novolak und strahlungsempfindlicher Verbindung, zugegeben werden. Diese Beschleuniger führen dazu, daß die Löslichkeit der Photoresistschicht sowohl in den belichteten als auch in den unbelichteten Bereichen zunimmt, und sie werden deshalb bei solchen

Anwendungen eingesetzt, bei denen es in erster Linie auf die Entwicklungsgeschwindigkeit ankommt, auch wenn dabei evtl. ein gewisser Grad an Kontrast geopfert wird, d.h. die belichteten Bereiche der Photoresistschicht werden vom Entwickler schneller gelöst. Gleichzeitig bewirken die anwesenden Entwicklungsbeschleuniger aber auch einen größeren Verlust an Photoresistschicht aus den unbelichteten Bereichen.

Geeignete Lösemittel sind zum Beispiel Xylol, Butylaceat und Ethylenglykolmonomethyletheracetat, die in einem Anteil bis zu 95 Gewichtsprozent in dem Lösungsmittel anwesend sein können; vorzugsweise werden jedoch in dem Gemisch keine zusätzlichen Lösemittel verwendet.

Als nicht-ionische Tenside können zum Beispiel Nonylphenoxy-poly(ethylenoxy)-ethanol, Octylphenoxy-(ethylenoxy)-ethanol, und Dinonylphenoxy-poly(ethylenoxy)-ethanol in einem Anteil bis zu 10 Gewichtsprozent, bezogen auf das gemeinsame Gewicht von Novolak und strahlungsempfindlicher Verbindung, verwendet werden.

Die erfindungsgemäße strahlungsempfindliche Beschichtungslösung kann nach einem der in der Photoresisttechnik üblichen Verfahren, wie Tauchen, Sprühen und Aufschleudern, auf einen Träger aufgebracht werden. Beim Aufschleudern kann zum Beispiel der Prozentanteil an Feststoffen in der Resistlösung so eingestellt werden, das sich bei dem verwendeten Beschichtungsgerät und bei der für das Aufschleudern angesetzten Zeitspanne eine Beschichtung in der gewünschten Dicke ergibt. Beispiele für geeignete Trägermaterialien sind: Silicium, Aluminium oder polymere Harze, Siliciumdioxid, dotiertes Siliciumdioxid, Siliciumnitrid, Tantal, Kupfer, polykristallines Silicium (polysilicon), Keramik und Aluminium/Kupfer-Legierungen.

Die nach dem beschriebenen Verfahren hergestellten Beschichtungslösungen eignen sich insbesondere zum Auftragen auf Silicium-Wafer, die eine Schicht aus thermisch gezüchtetem Siliciumdioxid tragen, wie sie bei der Herstellung von Mikroprozessoren und anderen Komponenten für miniaturisierte integrierte Schaltungen verwendet werden. Ebenso kann auch ein Wafer aus Aluminium/Aluminiumoxid genommen werden. Der Träger kann auch aus verschiedenen polymeren Harzen, insbesondere aus transparenten Polymeren, wie zum Beispiel Polyestern, bestehen.

Nach dem Auftragen der Beschichtungslösung auf den Träger wird der Träger bei etwa 80 bis 105°C über einige Minuten bis zu einer halben Stunde nacherhitzt, bis sich das Lösemittel im wesentlichen verflüchtigt hat.

Auf den beschichteten Träger kann dann mit aktinischer Strahlung, insbesondere mit UV-Strahlung, jedes gewünschte Belichtungsmuster aufbelichtet werden, das mit Hilfe von geeigneten Masken erzeugt wird.

Anschließend werden die belichteten resistbeschichteten Träger in eine alkalische Entwicklerlösung eingetaucht.

Die Lösung wird vorzugsweise bewegt, zum Beispiel durch Umwälzung mit Stickstoff. Die Träger werden so lange in dem Entwickler belassen, bis die gesamte Resistschicht der belichteten Bereiche weggelöst ist.

Nach dem Herausnehmen der beschichteten Wafer aus der Entwicklerlösung kann eine Wärmenachbehandlung durchgeführt werden, um die Haftung und die chemische Beständigkeit der Schicht gegen Ätzlösungen und andere Substanzen zu erhöhen. Die Wärmebehandlung kann in einem Ofen unterhalb des Erweichungspunktes der Schicht durchgeführt werden.

Bei technischen Anwendungen, insbesondere bei der Herstellung von Mikroschaltungseinheiten auf Silicium/Siliciumdioxid-Trägern können die entwickelten Träger mit einer gepufferten Ätzlösung auf der Basis von Fluorwasserstoffsäure behandelt werden. Die erfindungsgemäßen Resistgemische sind beständig gegen saure Ätzlösungen, und die unbelichteten Resistschichtbereiche auf dem Träger gewährleisten somit einen wirksamen Schutz des Trägers.

In den folgenden Beispielen werden die Verfahren zur Herstellung und Anwendung von erfindungsgemäßen Beschichtungslösungen eingehend erläutert. Diese Beispiele sollen jedoch die Erfindung in keiner Weise in ihrem Umfang einschränken, und sie sollen nicht dahingehend ausgelegt werden, daß sie Bedingungen, Parameter oder andere Werte angeben, die zur praktischen Ausführung der Erfindung ausschließlich anzuwenden sind.

## Beispiel 1

Zwei Beschichtungslösungen werden wie folgt hergestellt.

| Resist A | | Resist B | |
|---|---|---|---|
| Novolakharz | 23,8 % | Novolakharz | 23,8 % |
| photoaktive Komponente (Menge A) | 7,0 % | photoaktive Komponente (Menge A) | 7,0 % |
| Vergleichslösemittelgemisch aus 10 % Xylol, 10 % Butylacetat und 80 % Ethylenglykol-monomethyletheracetat | 69,2 % | Propylenglykolmethylether-acetat | 69,2 % |

Die photoaktive Komponente ist das Kondensationsprodukt aus 1,2-Naphthochinon-2-diazid-5-sulfonyl-chlorid und Trihydroxybenzophenon. Das Absorptionsvermögen von Resist A beträgt 1,31 und das von Resist B 1,33, wodurch sich bestätigt, daß sich das Niveau der photoaktiven Komponente in beiden Fällen entspricht. In beiden Fällen sind Novolakharz und photoaktive Komponente die gleichen. Das Harz wird in dem Lösemittel gelöst, wobei über Nacht gerührt wird, anschließend wird die photoaktive Komponente gelöst und die Lösung durch 0,2 µm-Millipore Teflonfilter filtriert.

## Beurteilung der Lichtempfindlichkeit

Die Beschichtungslösung wird mit einer festgelegten konstanten Schleudergeschwindigkeit auf mehrere Wafer aufgeschleudert. Dann werden die Wafer 30 Minuten bei 90°C nacherhitzt. Die anfänglichen Schichtdicken des aufgebrachten Photoresists werden mit einem Rudolf-Schichtdickenmeßgerät gemessen. Zur Messung der Lichtempfindlichkeit wird eine Kontrastkurve aufgetragen, wie in "Introduction to Microlithography" von G. C. Willson, Washington, D.C., 1983, American Chemical Society, Kapitel 3, S. 105, beschrieben. Dazu wird der Schichtdickenverlust nach einminütigem Entwickeln gegenüber dem Logarithmus der UV-Belichtungsdosis aufgetragen. Die Schichtdicke wird mit der beschriebenen Technik durch Laser-Interferometrie gemessen. Der Photoresist wird anschließend mit einer wäßrigen gepufferten alkalischen Lösung (AZ-Entwickler, hergestellt von American Hoechst Corporation, Somerville, New Jersey, USA, der mit entionisiertem Wasser im Verhältnis 1 : 1 verdünnt wurde) bei 25 ± 5°C entwickelt. Durch Extrapolation der Kurve auf den gesamten Schichtdickenverlust erhält man den Lichtempfindlichkeitswert (mJ/cm$^2$), und die Steigung dieser Kurve gibt den Kontrast an. Für die Resists A und B werden die folgenden Ergebnisse erhalten:

| | Resist A | Resist B |
|---|---|---|
| Lichtempfindlichkeit (mJ/cm$^2$) | 111,6 | 97,2 |
| Kontrast | 1,52 | 1,54 |

| anfängliche Schichtdicke | 1,811 | 1,797 |
| --- | --- | --- |

Die Ergebnisse zeigen, das bei Resist B die Lichtempfindlichkeit in einem vergleichbare Schichtdicken ergebenden Ansatz um 15 % verbessert ist. Es zeigt sich kein spürbarer Kontrastverlust.

## Schichtabtrag

Der Dickenverlust der Photoresistschicht in den unbelichteten Bereichen nach dem Entwickeln soll niedrig gehalten werden, um die Kantenschärfe zu erhalten. Je geringer der Schichtabtrag ist, desto geringer ist die für die Belichtung erforderliche Lichtmenge. Der Schichtabtrag wird gemessen, indem eine unbelichtete, nacherhitzte (90°C während 30 min) Photoresistschicht über einen Zeitraum von 10 min in dem mit entionisiertem Wasser im Verhältnis 1 : 1 verdünnten Entwickler entwickelt und anschließend der Schichtdickenverlust pro Minute berechnet wird. Die Ergebnisse für die Photoresists A und B sind wie folgt:

| | Resist A | Resist B |
| --- | --- | --- |
| Schichtabtrag (nm/min) | 1,7 | 1,0 |

Der Schichtabtrag von Resist B ist mit dem von Resist A mindestens vergleichbar.

## Beispiel 2

Es wird nach den Angaben von Beispiel 1 gearbeitet, mit dem Unterschied, daß eine andere Menge (Menge B) der gleichen photoaktiven Komponente eingesetzt wird.

| **Resist C** | | **Resist D** | |
| --- | --- | --- | --- |
| Novolakharz | 23,3 % | Novolakharz | 23,3 % |
| photoaktive Komponente (Menge B) | 6,9 % | photoaktive Komponente (Menge B) | 6,9 % |
| Vergleichslösemittelgemisch aus 10 % Xylol, 10 % Butylacetat und 80 % Ethylenglykolmonomethyletheracetat | 69,8 % | Propylenglykolmethyletheracetat | 69,8 % |

Die Nacherhitzungsdauer der Wafer nach dem Aufschleudern der Photoresists wird variiert, und Lichtempfindlichkeit und Kontrast werden gemessen, wie in Beispiel 1 angegeben.

| | **Resist C** | | **Resist D** | |
| --- | --- | --- | --- | --- |
| Nacherhitzungsdauer 90°C (Minuten) | Lichtempfind-lichkeit(mJ/cm$^2$) | Kontrast | Lichtempfind-lichkeit(mJ/cm$^2$) | Kontrast |
| 10 | 92 | 1,72 | 84 | 1,74 |
| 25 | - | - | 92 | 1,63 |
| 30 | 103 | 1,59 | 89 | 1,65 |

Die Lichtempfindlichkeit von Photoresist D ist verbessert, und zwar in den angegebenen Fällen von 9 bis 16 %.

## Flammpunkte der Photoresists

Aus Sicherheitsgründen ist ein höherer Flammpunkt eine wünschenswerte Eigenschaft. Die Flammpunkte der Photoresists C und D wurden in einem ASTM-Test (D93, Methode A) verglichen.

| | **Flammpunkt** |
| --- | --- |
| Resist C | 42°C |
| Resist D | 48°C |

Der Resist D ist in bezug auf den Flammpunkt erheblich verbessert.

## Plasmaätzrate

Die Plasmaätzrate einer Resistschicht soll zum trockenen Verarbeiten so niedrig wie möglich gehalten werden.

Um diese zu testen, werden mit Photoresist beschichtete Proben einem starken Schichthärten durch Nacherhitzen bei 140°C während 30 Minuten unterzogen. Nachfolgend sind die Plasmaätzraten der Resists C und D angegeben. Die Testbedingungen in einem Plasmaätzgerät sind wie folgt:

Leistung: 150 W
Druck: 0,6 Torr
Verhältnis $CF_4/O_2$: 95/5
$O_2$-Durchflußgeschwindigkeit: 60 Scm³ (Standardkubikzentimeter).

|  | Ätzrate |
|---|---|
| Resist C | 33,4 |
| Resist D | 31,3 |

Die Plasmaätzrate des Resists D ist mit der des Resists C mindestens vergleichbar.

## Eindringtiefentest (DOP-Test)

Der Eindringtiefentest, beschrieben von D. J. Elliot in "Integrated Circuit Fabrication Technology", New York, McGraw Hill Book Company, 1982, Kapitel 13, S. 325, gibt weiterhin ein Maß für die Lichtempfindlichkeit eines positiv-arbeitenden Photoresists. In diesem Test wird die Photoresistschichtdicke gemessen, die bei einer bestimmten UV-Lichtmenge nach dem Entwickeln entfernt worden ist. Je größer die Schichtdicke ist, die entfernt wird, desto größer ist die Lichtempfindlichkeit. Es folgen die Ergebnisse, die beim Entwickeln mit dem in Beispiel 1 genannten Entwickler, verdünnt mit entionisiertem Wasser im Verhältnis 1 : 1, erhalten werden.

| Lichtmenge (mJ/cm²) | Resist A (µm) | Resist B (µm) |
|---|---|---|
| 15,0 | 0,45 | 0,53 |
| 22,0 | 0,75 | 0,80 |
| 26,0 | 0,95 | 1,07 |
| 31,0 | 0,10 | 1,44 |
| 36,5 | 1,35 | 1,58 |

Aus diesem Test ergibt sich, daß der Resist B eine größere Lichtempfindlichkeit hat.

## Die Abhängigkeit der Schichtdicke von der Schleudergeschwindigkeit (Aufschleuderkurven)

Aufschleuderkurven werden verwendet, um aufgrund der Aufschleudergeschwindigkeit die Dicke der nacherhitzten Photoresistschicht im voraus festzusetzen. Diese Kurven müssen daher regelmäßig sein und eine gerade Linie bilden, wenn sie in logarithmischen Maßstäben als Schichtdicke gegenüber der Aufschleudergeschwindigkeit aufgetragen werden. Die beiden Photoresists C und D werden jeweils mit verschiedenen Geschwindigkeiten, wie unten angegeben, aufgeschleudert, während 30 Minuten bei 90°C nacherhitzt und die Photoresistschichtdicke gemessen.

| U/min | Resist C | Resist D |
|---|---|---|
| 2.000 | 2,47 (µm) | 2,79 (µm) |
| 3.000 | 1,99 | 2,28 |
| 4.000 | 1,77 | 1,95 |
| 5.000 | 1,51 | 1,74 |
| 6.000 | 1,38 | 1,60 |
| 7.000 | 1,28 | 1,47 |

Wird das Kurvenbild wie angegeben aufgetragen, so ergibt sich für jeden Resist eine geradlinige Kurve. Da Resist D eine höhere Viskosität hat als Resist C (29,6 cSt gegenüber 37,8 cSt), sind die beiden Kurven gegeneinander versetzt. Jeder Photoresist bildet jedoch eine ordentliche Aufschleuderkurve, wie man sie zur Vorausbestimmung der Schichtdicken benötigt.

**Beispiel 3**

Es wird nach dem Verfahren von Beispiel 1 gearbeitet,

| **Resist A** | | **Resist B** | |
|---|---|---|---|
| Novolakharz | 23,8 % | Novolakharz | 23,8 % |
| photoaktive Komponente | 7,0 | photoaktive Komponente | 7,0 |
| Vergleichslösemittelgemisch aus 10 % Xylol, 10 % Butylacetat und 80 % Ethylenglykolmonomethyletheracetat | 69,2 % | Lösemittelgemisch aus 10 % Xylol, 10 % Butylacetat und 80 % Propylenglykolmethyletheracetat | 69,2 % |

| | **Resist A** | **Resist B** |
|---|---|---|
| Lichtempfindlichkeit (mJ/cm$^2$) | 111,6 | 98,2 |
| Kontrast | 1,52 | 1,54 |
| anfängliche Schichtdicke | 1,811 | 2,170 |

Die Ergebnisse zeigen, daß Resist B eine Verbesserung der Lichtempfindlichkeit um 12 % ergibt, selbst wenn das Propylenglykolmethyletheracetat in Verbindung mit anderen Lösemitteln eingesetzt wird. Das ist insbesondere deshalb überraschend, weil Resist B eine erheblich größere Schichtdicke aufweist.

**Beispiel 4**

Es wird nach dem Verfahren von Beispiel 1 gearbeitet, mit dem Unterschied, daß zusätzlich ein Weichmacher verwendet wird.

| **Resist A** | | **Resist B** | |
|---|---|---|---|
| Polymethylvinylether | 15,43 % | Polymethylvinylether | 15,43 % |
| Novolakharz | 20,12 % | Novolakharz | 20,12 % |
| photoaktive Komponente | 5,96 % | photoaktive Komponente | 5,96 % |
| Vergleichslösemittelgemisch aus 10 % Xylol, 10 % Butylacetat und 80 % Ethylenglykolmonomethyletheracetat | 58,5 % | Propylenglykolmethyletheracetat | 58,5 % |

| | **Resist A** | **Resist B** |
|---|---|---|
| anfängliche Schichtdicke | 6,05 μm | 6,74 μm |
| Lichtempfindlichkeit (mJ/cm$^2$) | 114,85 | 100,0 |

Die Ergebnisse zeigen, daß Resist B eine um 14,85 % verbesserte Lichtempfindlichkeit in vergleichbaren Ansätzen mit einem Gehalt an Weichmacher (Polymethylvinylether) ergibt.

## Beispiel 5

Drei Beschichtungslösungen wurden wie folgt hergestellt:

| Bezeichnung | Novolak | Naphthochinondiazid wie in Beispiel 1 | Lösemittel |
|---|---|---|---|
| Resist A | 23,5 % | 7,5 % | 80 % Ethylenglykolmethyletheracetat, 10 % Xylol 10 % Butylacetat |
| Resist B | 23,5 % | 7,5 % | Propylenglykolmethyletheracetat |
| Resist C | 23,5 % | 7,5 % | Propylenglykolethyletheracetat |

Wie in Beispiel 1 beschrieben, wurde die Lichtempfindlichkeit der drei Gemische ermittelt. Die folgenden Ergebnisse wurden erhalten:

| Resist | Viskosität $mm^2/s$ | Extinktion Liter/g·cm | Lichtempfindlichkeit $mJ/cm^2$ |
|---|---|---|---|
| A | 31,2 | 1,29 | 88 |
| B | 36,4 | 1,26 | 84 |
| C | 56,6 | 1,25 | 80 |

Die Mischungen B und C zeigen eine gegenüber A erhöhte Lichtempfindlichkeit. Auch zeigt der Resist C, der mit dem entsprechenden Ethylether hergestellt wurde, eine höhere Lichtempfindlichkeit als der mit dem Methylether hergestellte Resist B. Nach bildmäßiger Belichtung unter einer hochauflösenden Maske konnten ohne Schwierigkeiten Strukturen von 1 μm mit steilen Resistflanken aufgelöst werden.

## Patentansprüche

1. Positiv-arbeitende strahlungsempfindliche Beschichtungslösung, die als wesentliche Bestandteile mindestens ein wasserunlösliches, in wäßrig-alkalischen Lösungen lösliches polymeres Bindemittel, mindestens eine strahlungsempfindliche Verbindung und ein organisches Lösungsmittel bzw. Lösemittelgemisch aus oder mit einem Glykoletherester enthält, dadurch gekennzeichnet, daß der Glykoletherester ein Propylenglykol-$C_1$-$C_2$-alkyletheracetat ist.

2. Beschichtungslösung nach Anspruch 1, dadurch gekennzeichnet, daß der Glykoletherester ein Propylenglykolmethyletheracetat ist.

3. Beschichtungslösung nach Ansprüchen 1 bis 2, dadurch gekennzeichnet, daß sie das Propylenglykol-$C_1$-$C_2$-alkyletheracetat in einer Menge von 5 bis 100 Gewichtsprozent, bezogen auf das Lösemittel, enthält.

4. Beschichtungslösung nach Anspruch 1 dadurch gekennzeichnet, daß sie als polymeres Bindemittel ein Novolakharz enthält.

5. Beschichtungslösung nach Anspruch 1 dadurch gekennzeichnet, daß sie als strahlungsempfindliche Verbindung ein mit Hydroxybenzophenonen kondensiertes 1,2-Naphthochinondiazid-5-sulfonylchlorid bzw. 1,2-Naphthochinondiazid-4-sulfonylchlorid enthält.

## Claims

1. Positive-working radiation-sensitive coating solution which contains, as essential constituents, at least one water-insoluble polymeric binder which is soluble in aqueous alkali solutions, at least one radiation-sensitive compound and one organic solvent or solvent mixture of or with a glycol ether ester, characterized in that the glycol ester is a propylene glycol ($C_1$-$C_2$)alkyl ether acetate.

2. Coating solution according to Claim 1, characterized in that the glycol ether ester is a propylene glycol methyl ether acetate.

3. Coating solution according to Claims 1 to 2, characterized in that it contains the propylene glycol ($C_1$-$C_2$)alkyl ether acetate in a quantity of 5 to 100 % by weight, based on the solvent.

4. Coating solution according to Claim 1, characterized in that it contains a novolak resin as polymeric binder.

5. Coating solution according to Claim 1, characterized in that it contains, as radiation-sensitive compound, a 1,2-naphthoquinonediazide-5-sulfonyl chloride or 1,2-naphthoquinonediazide-4-sulfonyl chloride condensed with hydroxybenzophenones.

**Revendications**

1. Solution de revêtement photosensible travaillant en positif, qui contient comme constituants essentiels au moins un liant polymère insoluble dans l'eau et soluble dans des solutions alcalines aqueuses, au moins un composé photosensible, et un solvant organique ou un mélange de solvants organiques consistant en, ou avec un éther-ester de glycol, caractérisée en ce que l'éther-ester de glycol est un alkyl en $C_1$-$C_2$ étheracétate de propylèneglycol.

2. Solution de revêtement selon la revendication 1, caractérisée en ce que l'éther-ester de glycol est un méthylétheracétate de propylèneglycol.

3. Solution de revêtement selon les revendications 1 à 2, caractérisée en ce qu'elle renferme le alkyl en $C_1$-$C_2$ étheracétate de propylèneglycol en une proportion de 5 à 100 % en poids, par rapport au solvant.

4. Solution de revêtement selon la revendication 1, caractérisée en ce qu'elle renferme, comme liant polymère, une résine novolaque.

5. Solution de revêtement selon la revendication 1, caractérisée en ce qu'elle renferme, comme composé photosensible, un chlorure de 1,2-naphtoquinonediazide-5-sulfonyle ou un chlorure de 1,2-naphtoquinonediazide-4-sulfonyle condensé avec des hydroxybenzophénones.